(19) Europäisches Patentamt
European Patent Office
Office européen des brevets

(11) **EP 3 201 610 B1**

(12) **FASCICULE DE BREVET EUROPEEN**

(45) Date de publication et mention de la délivrance du brevet:
**07.11.2018 Bulletin 2018/45**

(51) Int Cl.:
**G01N 21/95** *(2006.01)*    **G01B 11/24** *(2006.01)*
**G01N 21/88** *(2006.01)*

(21) Numéro de dépôt: **15774574.6**

(22) Date de dépôt: **29.09.2015**

(86) Numéro de dépôt international:
**PCT/EP2015/072368**

(87) Numéro de publication internationale:
**WO 2016/050738 (07.04.2016 Gazette 2016/14)**

(54) **PROCÉDÉ ET SYSTÈME D'INSPECTION DE PLAQUETTES TRANSPARENTES POUR L'ÉLECTRONIQUE, L'OPTIQUE OU L'OPTOÉLECTRONIQUE**

VERFAHREN UND SYSTEM ZUR ÜBERPRÜFUNG TRANSPARENTER WAFER FÜR ELEKTRONIK, OPTIK UND OPTO-ELEKTRONIK

METHOD AND SYSTEM FOR INSPECTING TRANSPARENT WAFERS FOR ELECTRONICS, OPTICS OR OPTOELECTRONICS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **29.09.2014  FR 1459170**

(43) Date de publication de la demande:
**09.08.2017  Bulletin 2017/32**

(73) Titulaire: **Unity Semiconductor**
**38330 Montbonnot Saint Martin (FR)**

(72) Inventeurs:
• **DURAND DE GEVIGNEY, Mayeul**
**38240 Meylan (FR)**
• **GASTALDO, Philippe**
**F-38530 Pontcharra (FR)**

(74) Mandataire: **IPAZ**
**Parc Les Algorithmes, Bâtiment Platon**
**CS 70003 Saint-Aubin**
**91192 Gif-sur-Yvette Cedex (FR)**

(56) Documents cités:
**WO-A1-2009/112704    WO-A2-02/39099**
**US-A- 4 030 830**

• **LEMAITRE-AUGER P ET AL: "Integrated laser doppler velocimeter for fluid velocity and wall friction measurements", PROCEEDINGS OF IEEE SENSORS 2002. ORLANDO, FL, JUNE 12 - 14, 2002; [IEEE INTERNATIONAL CONFERENCE ON SENSORS], NEW YORK, NY : IEEE, US, vol. 1, 12 juin 2002 (2002-06-12), pages 78-82, XP010605058, DOI: 10.1109/ICSENS.2002.1036992 ISBN: 978-0-7803-7454-6 cité dans la demande**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

# Description

## DOMAINE DE L'INVENTION

La présente invention concerne un procédé et un système d'inspection de plaquettes pour l'électronique, l'optique ou l'optoélectronique, lesdites plaquettes étant partiellement ou totalement transparentes à la longueur d'onde de la source lumineuse utilisée pour réaliser l'inspection.

## ARRIERE PLAN DE L'INVENTION

Lors de la fabrication et l'utilisation de plaquettes (ou « wafers » selon la terminologie anglo-saxonne) pour l'électronique, l'optique ou l'optoélectronique, il est habituel de réaliser une inspection de la surface de chaque plaquette afin d'y détecter d'éventuels défauts.

En raison de la très faible taille des défauts à détecter, une inspection visuelle par un opérateur n'est pas suffisante.

Par ailleurs, l'inspection ne vise généralement pas uniquement à déceler la présence ou non de défauts, mais aussi à fournir des informations qualitatives et/ou quantitatives sur lesdits défauts, telles que leur localisation, leur taille et/ou leur nature, par exemple.

Des systèmes d'inspection ont donc été développés en vue de détecter des défauts de plus en plus petits et de fournir toutes informations requises sur la nature, la taille, la localisation, etc. desdits défauts.

Ces systèmes doivent en outre permettre une durée d'inspection de chaque plaquette qui soit suffisamment courte pour ne pas pénaliser les cadences de fabrication. Différentes techniques d'inspection sont connues.

Une première technique est la vélocimétrie laser à effet Doppler (LDV, acronyme du terme anglo-saxon « Laser Doppler Velocimetry »).

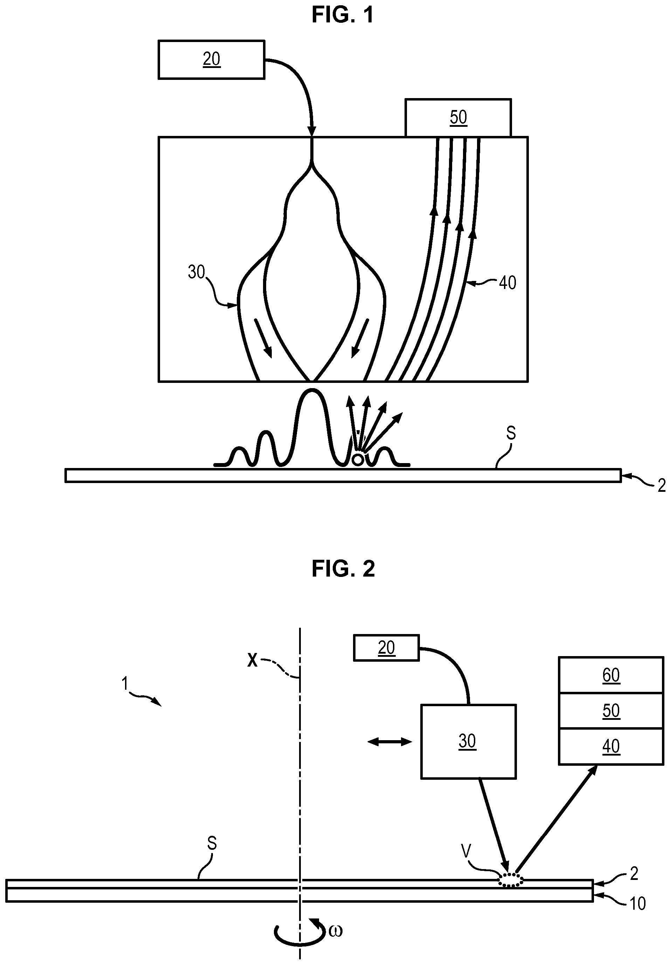

Le document WO 2009/112704 décrit un système d'inspection de plaquettes semiconductrices mettant en oeuvre cette technique. Comme on peut le voir sur la figure 1, ce système comprend une source lumineuse 20 et un dispositif interférométrique 30 couplé à la source lumineuse agencé en regard de la surface S de la plaquette 2 à inspecter, qui est animée d'un mouvement. Ledit dispositif interférométrique comprend un guide de lumière dont l'entrée est couplée à la source lumineuse et comprenant deux branches pour diviser le faisceau issu de la source lumineuse en deux faisceaux incidents. A la sortie du guide de lumière, les deux branches sont orientées l'une par rapport à l'autre de sorte à former, à l'intersection entre les deux faisceaux, un volume de mesure comprenant une pluralité de franges parallèles. Le système comprend par ailleurs une fibre optique 40 agencée entre la surface de la plaquette et un module de détection 50, de sorte à guider vers le module de détection la lumière rétro-diffusée par la surface de la plaquette.

La présence d'un défaut sur la surface de la plaquette se traduit, lorsque ce défaut traverse les franges d'interférences, par la diffusion d'une bouffée Doppler mesurée par le module de détection. Une bouffée Doppler est un signal présentant une double composante fréquentielle : une composante de fréquence basse, formant l'enveloppe du signal, correspondant à l'intensité lumineuse moyenne diffusée par le défaut, et une composante de fréquence haute, correspondant à la fréquence Doppler contenant l'information sur la vitesse du défaut. La fréquence Doppler $f_D$ est liée à la vitesse $v$ de déplacement du défaut dans la direction perpendiculaire aux franges et à la distance $\Delta$ entre les franges d'interférences (ou distance interfranges) par la relation : $v = f * \Delta$.

Le document WO 02/39099 décrit un autre système d'inspection de plaquettes semiconductrices reposant sur la vélocimétrie laser à effet Doppler.

Une autre technique connue d'inspection de plaquettes est la microscopie en champ sombre (« dark field » selon la terminologie anglo-saxonne), qui consiste à émettre à partir d'une source lumineuse un faisceau en direction de la plaquette et à mesurer l'intensité de la lumière rétro-diffusée par la surface. Une variation de l'intensité diffusée révèle la présence d'un défaut à la surface de la plaquette.

Ces différentes techniques s'appliquent à des plaquettes opaques à la longueur d'onde du faisceau.

En revanche, aucune technique connue ne permet d'inspecter de manière satisfaisante des plaquettes qui sont au moins partiellement transparentes à la longueur d'onde de la source lumineuse (lesdites plaquettes étant dites « transparentes » dans la suite du texte.

En effet, dans ce cas, des défauts présents à la surface de la plaquette (sur la face exposée au faisceau lumineux et/ou sur la face opposée) mais aussi dans l'épaisseur de la plaquette diffusent la lumière incidente et peuvent donc être détectés. Il n'est donc pas possible de savoir si chaque défaut détecté se trouve sur la surface à inspecter ou non.

La société KLA-Tencor propose un système d'inspection de plaquettes transparentes dénommé Candela™, de type système à balayage laser et détection confocale. Cependant, ce système est particulièrement difficile à mettre au point du fait de la précision de positionnement requise pour la mesure confocale, et ne fournit donc pas des résultats répétables.

## BREVE DESCRIPTION DE L'INVENTION

Un but de l'invention est de résoudre les problèmes précités et de concevoir un système et un procédé d'inspection de plaquettes transparentes qui offre une sensibilité et une répétabilité des mesures supérieures à celles des techniques connues.

Conformément à l'invention, il est proposé un procédé d'inspection d'une plaquette pour l'électronique, l'optique ou l'optoélectronique, selon la revendication 1.

Selon un mode de réalisation préféré, ledit dispositif interférométrique est un dispositif optique intégré comprenant un guide de lumière dont l'entrée est couplée à la source lumineuse et qui se divise en deux branches dont la sortie est orientée pour former ledit volume de mesure à l'intersection des deux faisceaux.

Par « faisceau quasi-collimaté » on entend un faisceau non collimaté, présentant une faible divergence, c'est-à-dire une divergence non nulle typiquement inférieure à 20°.

De manière particulièrement avantageuse, la distance interfranges varie dans la direction radiale de la plaquette.

De préférence, la distance interfranges varie entre une distance minimale à l'extrémité du volume de mesure la plus éloignée de l'axe de rotation de la plaquette et une distance maximale à l'extrémité du volume de mesure la plus proche de l'axe de rotation de la plaquette.

Selon un mode de réalisation, dans le volume de mesure, la distance interfranges varie dans un intervalle de ± 50% autour d'une valeur nominale.

Selon une forme d'exécution de l'invention, principalement dédiée à la détermination de la position radiale d'un défaut, le volume de mesure est incliné d'un angle compris entre 10 et 80° par rapport à normale à la surface principale de la plaquette.

Selon une autre forme d'exécution de l'invention, principalement dédiée à déterminer la position d'un défaut dans l'épaisseur de la plaquette, le volume de mesure est incliné d'un angle compris entre 0 et 40° par rapport à la normale à la surface principale de la plaquette.

Selon un mode de réalisation, le procédé comprend en outre la mise en oeuvre d'un filtrage passe-bande du signal, la bande passante dudit filtre étant sélectionnée pour ne transmettre que la partie du signal présentant la fréquence Doppler associée à une position déterminée dans l'épaisseur de la plaquette.

Un autre objet concerne un système d'inspection de plaquettes pour l'électronique, l'optique ou l'optoélectronique, selon la revendication 9.

Selon un mode de réalisation préféré, le dispositif interférométrique est un dispositif optique intégré.

De manière particulièrement avantageuse, le système comprend en outre un bras pour déplacer le dispositif interférométrique et le dispositif de collecte de la lumière diffusée en translation dans une direction radiale.

## BREVE DESCRIPTION DES DESSINS

D'autres caractéristiques et avantages de l'invention ressortiront de la description détaillée qui va suivre, en référence aux dessins annexés sur lesquels :

- la figure 1 est un schéma de principe d'un système d'inspection basé sur la vélocimétrie laser à effet Doppler, décrit dans le document WO 2009/112704,

- la figure 2 est un schéma de principe d'un système d'inspection selon l'invention,

- les figures 3A et 3B illustrent le volume de mesure par rapport à la surface de la plaquette, respectivement en vue de côté et en vue de dessus, selon un premier mode de réalisation de l'invention,

- les figures 4A et 4B illustrent de manière schématique les bouffées Doppler obtenues respectivement pour un volume de mesure dans lequel les franges d'interférences sont parallèles et pour un volume de mesure selon le premier mode de réalisation de l'invention, dans lequel les franges d'interférences présentent un espacement variable dans la direction radiale de la plaquette,

- la figure 5 présente les courbes de variation de la fréquence Doppler (en %) en fonction de la distance r par rapport au centre de la plaquette, pour un volume de mesure dans lequel les franges d'interférences sont parallèles (courbe (a)) et pour un volume de mesure selon le premier mode de réalisation de l'invention (courbe (b)),

- les figures 6A et 6B illustrent le volume de mesure par rapport à la surface de la plaquette, respectivement en vue de côté et en vue de dessus, selon un deuxième mode de réalisation de l'invention,

- la figure 7 est un logigramme présentant les différentes étapes de la localisation d'un défaut dans le volume de la plaquette,

- la figure 8 illustre la détection de défauts en différents emplacements dans l'épaisseur de la plaquette selon le deuxième mode de réalisation, mettant en oeuvre un filtre passe-bande conventionnel,

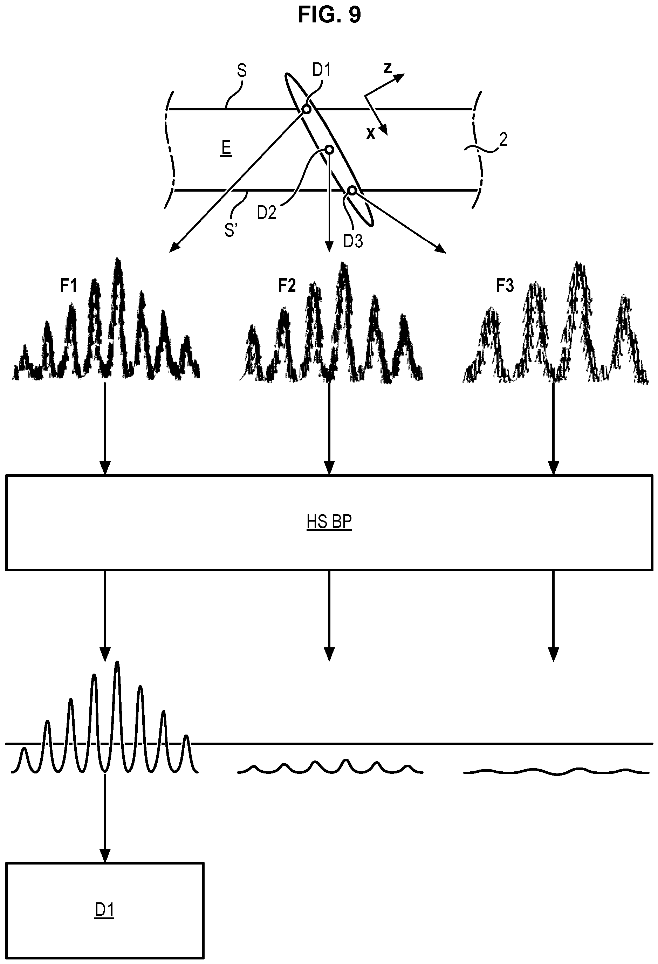

- la figure 9 illustre la détection de défauts en un emplacement déterminé dans l'épaisseur de la plaquette, selon le deuxième mode de réalisation en combinaison avec un filtre passe-bande à haute sélectivité.

Pour faciliter la lecture des figures, celles-ci ne sont pas nécessairement réalisées à l'échelle.

## DESCRIPTION DETAILLEE DE L'INVENTION

On s'intéresse dans la présente invention à toute plaquette destinée à être utilisée dans le domaine de l'électronique, de l'optique ou de l'optoélectronique, et étant au moins partiellement transparente à la longueur d'onde d'un faisceau émis par une source lumineuse. En particulier, la plaquette peut comprendre au moins l'un des matériaux suivants : verre, saphir, quartz, SiC, As-Ga, GaN (liste non limitative).

De manière particulièrement avantageuse, l'invention s'affranchit des contraintes liées à la technique confocale en détectant les défauts par une signature fréquentielle, qui ne peut être émise que par des défauts traversant un volume de mesure créé par un vélocimètre laser à effet Doppler.

Dans un tel système, le positionnement du dispositif interférométrique doit donc être ajusté précisément par rapport à la surface de la plaquette à inspecter, pour que la région de plaquette à inspecter traverse au moins une partie du volume de mesure ; en revanche, le dispositif de collecte de la lumière rétro-diffusée ne requiert pas une aussi grande précision de positionnement puisque c'est par la fréquence Doppler qu'est effectuée la restriction du volume de mesure et donc la détection.

Par ailleurs, le montrera plus bas la description de certains modes de réalisation, l'invention permet de détecter des défauts avec une résolution plus grande que la dimension du volume de mesure, dans la direction radiale et/ou dans la direction de l'épaisseur de la plaquette.

Le principe du système d'inspection 1 est illustré sur la figure 2.

Le système comprend un support 10 destiné à recevoir une plaquette 2 à inspecter et à l'entraîner en rotation autour d'un axe de symétrie X de la plaquette perpendiculaire à une surface principale S de ladite plaquette. En général, la plaquette est de forme circulaire mais l'invention peut s'appliquer à toute autre forme.

La plaquette 2 est maintenue sur le support 10 par tout moyen approprié, tel que des moyens électrostatiques, des moyens mécaniques, etc.

Le mécanisme de mise en rotation du support est connu en lui-même et ne sera donc pas décrit de manière détaillée.

Le support 10 comprend un ou plusieurs encodeurs (non illustrés) permettant de connaître à chaque instant la position angulaire de la plaquette.

Le système d'inspection 1 comprend en outre une source lumineuse 20.

La source lumineuse 20 est typiquement un laser de type DFB (acronyme du terme anglo-saxon « Distributed Feed Back »).

La source lumineuse est couplée à un dispositif interférométrique 30 qui sera décrit en détail plus bas.

Le système d'inspection comprend par ailleurs un dispositif 40 de collecte de la lumière rétro-diffusée par la région de la plaquette traversant le volume de mesure. Ce dispositif 40 peut comprendre une fibre optique de préférence de grand diamètre de coeur (c'est-à-dire typiquement entre 100 et 1000 $\mu$m de diamètre), dont l'entrée est agencée en regard de la surface de la plaquette, à proximité du volume de mesure, et dont la sortie est couplée à un dispositif 50 d'acquisition de la lumière collectée pour émettre un signal électrique représentant la variation de l'intensité lumineuse de la lumière collectée en fonction du temps. Ledit dispositif 50 comprend typiquement un photodétecteur.

De préférence, le dispositif interférométrique 30 et le dispositif 40 de collecte de la lumière rétro-diffusée sont rigidement solidaires l'un de l'autre. En effet, l'entrée du dispositif de collecte 40 doit être positionné de manière appropriée par rapport au volume de mesure pour recevoir la lumière rétro-diffusée par la plaquette.

Le dispositif interférométrique 30 comprend un guide de lumière dont l'entrée est couplée à la source lumineuse 20 et qui comprend deux branches symétriques pour diviser le faisceau issu de la source lumineuse en deux faisceaux incidents. A son extrémité, chaque branche présente une portion élargie destinée à élargir le faisceau tout en lui conservant un profil gaussien. A la sortie du guide de lumière, les branches sont orientées l'une par rapport à l'autre de sorte à former, à l'intersection entre les deux faisceaux, un volume de mesure V contenant des franges d'interférences.

De manière particulièrement avantageuse, le dispositif interférométrique se présente sous la forme d'un dispositif optique intégré constitué d'une seule pièce et assurant à la fois la séparation du faisceau émis par la source lumineuse et la transmission des deux branches du faisceau pour former les volumes d'interférences à la sortie du capteur. On rappelle qu'un dispositif optique intégré est un dispositif optique fabriqué par des techniques de microélectronique.

L'article « Integrated Laser Doppler Velocimeter for Fluid Velocity and Wall Friction Measurements » de P. Lemaitre-Auger et al. décrit un tel dispositif optique intégré.

Un tel dispositif est fabriqué notamment par la société A2 Photonic Sensor et commercialisé sous la référence I-LDA™.

A titre d'exemple, le dispositif optique intégré peut être fabriqué par échange d'ions sur un substrat de verre. Ce procédé comprend d'une manière générale :

- la fourniture d'un substrat de verre,
- le dépôt d'une couche de masquage métallique sur ledit substrat de verre,
- le dépôt d'une couche polymère sur la couche métallique,
- le transfert par photolithographie d'un motif définissant la forme du guide de lumière sur la couche polymère,
- la gravure chimique de la couche de masquage métallique à l'aide d'un procédé chimique dans les zones laissées exposées par le masque polymère,
- la suppression du masque polymère,
- l'immersion du substrat recouvert de la couche de masquage métallique gravée dans un bain d'ions (par exemple un bain de nitrate de potassium),
- l'échange d'ions présents dans le bain (par exemple des ions potassium) et d'ions contenus dans le verre (par exemple des ions sodium) au travers des zones du substrat non recouvertes par la couche de masquage métallique, celle-ci bloquant le passage des ions.

En raison de la différence de taille entre les ions présents dans le bain et les ions présents dans le verre, l'échange d'ions génère dans le substrat de verre des contraintes mécaniques locales qui augmentent l'indice de réfraction du verre. On obtient ainsi le guide de lumière mentionné plus haut.

On retire ensuite la couche de masquage métallique et l'on dépose éventuellement une couche protectrice, par exemple de $SiO_2$. Enfin, on découpe les bords du substrat et on les polit finement.

Il existe d'autres procédés de fabrication de dispositifs optiques intégrés et l'homme du métier pourra choisir parmi les technologies de microélectronique à sa disposition pour concevoir le dispositif optique intégré.

Eventuellement, le dispositif optique intégré peut être associé en outre à une fibre optique permettant de collecter la lumière rétro-diffusée.

Un avantage de ce dispositif intégré est sa robustesse et sa stabilité. En particulier, contrairement à un système réalisé par d'autres techniques telles que la micro optique ou les fibres optiques, la compacité du dispositif intégré et l'intégration des différents composants le rendent insensible aux vibrations et aux gradients de température.

Par ailleurs, on fait en sorte que la région dans laquelle s'étend chaque volume de mesure présente une épaisseur inférieure à celle de la plaquette (cette région incluant une portion de la surface à inspecter). L'épaisseur de ladite région est de préférence inférieure ou égale à 90% de l'épaisseur de la plaquette. Par exemple, pour une plaquette de 500 $\mu$m à 1 mm d'épaisseur, on fait en sorte que les volumes de mesure s'étendent dans une région de la plaquette présentant une épaisseur inférieure ou égale à 100 $\mu$m.

La dimension du volume de mesure est caractéristique du dispositif interférométrique et est définie par l'angle entre les deux branches du guide de lumière dans lesquelles se propage le faisceau lumineux émis par la source et par l'ouverture numérique desdits branches. Ces caractéristiques sont donc figées lors de la fabrication du dispositif optique intégré, ce qui permet de garantir une bonne maîtrise des performances du système lors de sa production en série.

Ainsi, il est possible de limiter ce volume de mesure à la surface de la plaquette ou à une région du voisinage de ladite surface.

On assure ainsi que les défauts détectés se trouvent sur la surface à inspecter ou à son proche voisinage, et non sur la surface opposée de la plaquette.

Un dispositif optique intégré présente un avantage supplémentaire dans ce contexte, dans la mesure où sa stabilité permet d'éviter une dérive de la profondeur de champ. Le contrôle de la profondeur de champ permis par le dispositif intégré facilite donc l'inspection de plaquettes transparentes par vélocimétrie laser à effet Doppler.

On notera que, par contraste, le contrôle de la profondeur de champ revêt une importance moins grande pour l'inspection d'une plaquette opaque dans la mesure où, le volume de mesure ne pénétrant pas dans l'épaisseur d'une telle plaquette, il suffit qu'une partie de la surface de la plaquette passe dans le volume de mesure pour permettre l'inspection de ladite surface.

Enfin, le système d'inspection 1 comprend un dispositif 60 de traitement configuré pour détecter, dans ledit signal, une composante fréquentielle correspondant à la fréquence Doppler.

Le dispositif de traitement 60 est avantageusement couplé à une interface (non illustrée) permettant à un utilisateur d'accéder aux résultats de l'inspection afin notamment de les visualiser, de les enregistrer et/ou de les imprimer.

Selon un mode de réalisation particulièrement avantageux de l'invention, le système d'inspection est conçu pour produire un volume de mesure contenant des franges d'interférences qui ne sont pas parallèles (c'est-à-dire ne présentant pas une distance interfranges constante), mais dont la distance interfranges varie dans ledit volume de mesure.

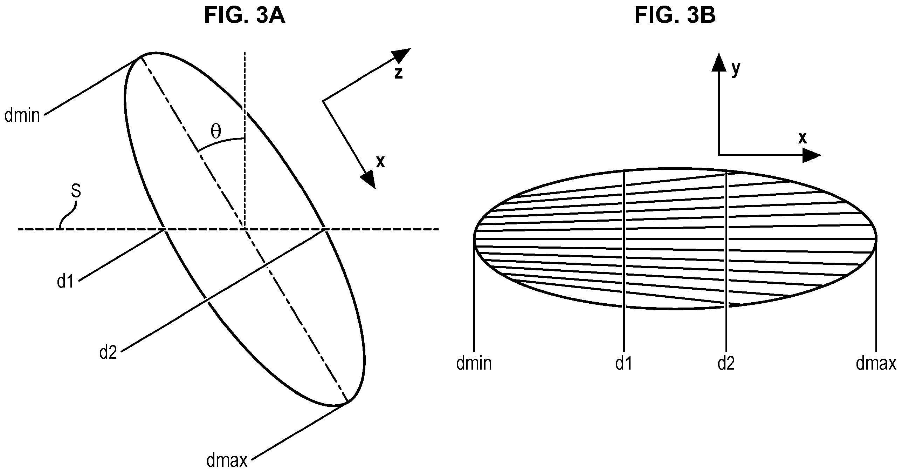

Comme cela sera expliqué plus bas en référence aux figures 3A et 3B, la variation de distance interfranges est choisie suffisamment grande pour permettre d'obtenir une fréquence Doppler suffisamment différente d'un point à un autre du volume de mesure. Cette variation de la distance interfranges est obtenue par l'émission, par la source 20, d'un faisceau lumineux qui est quasi-collimaté, c'est-à-dire qui présente une divergence non nulle et inférieure à 20°. Grâce à cette propriété des faisceaux, la distance interfranges augmente linéairement le long de la direction de propagation des faisceaux.

Comme indiqué dans l'article de P. Lemaitre-Auger précité, la distance interfranges dépend de la longueur d'onde de la source lumineuse, de l'indice optique du guide de lumière et de l'angle entre les deux branches du guide de lumière. Pour une longueur d'onde donnée de la source lumineuse, la distance interfranges moyenne est donc figée lors de la fabrication du dispositif optique intégré, la variabilité de la distance interfranges étant obtenue par le caractère quasi-collimaté du faisceau émis par la source.

Pour inspecter une plaquette, on met en place ladite plaquette 2 sur le support 10 et l'on entraîne le support en rotation à une vitesse angulaire $\omega$ contrôlée. Grâce aux encodeurs présents sur le support 10, on connaît à chaque instant la position angulaire d'un point donné de la plaquette. La vitesse de rotation de la plaquette est typiquement de l'ordre de 5000 tours/min.

Dans le système d'inspection 1, le dispositif interférométrique 30 est agencé en regard d'une surface principale de la plaquette 2, sur un bras (non illustré) adapté pour déplacer ledit dispositif 30 dans une direction radiale. Ainsi, compte tenu de la rotation de la plaquette, on peut balayer successivement l'ensemble de la surface de la plaquette avec le volume de mesure en translatant radialement le dispositif interférométrique ainsi que le dispositif de collecte de la lumière rétro-diffusée.

On fait en sorte que les franges d'interférences s'étendent transversalement à la trajectoire de rotation de la plaquette, perpendiculaires ou inclinées d'un angle non nul par rapport à cette trajectoire.

Selon un mode de réalisation (non illustré), le volume de mesure s'étend dans une direction parallèle à la normale à la surface principale de la plaquette Tel peut être le cas notamment lorsque la distance interfranges est constante au sein du volume de mesure.

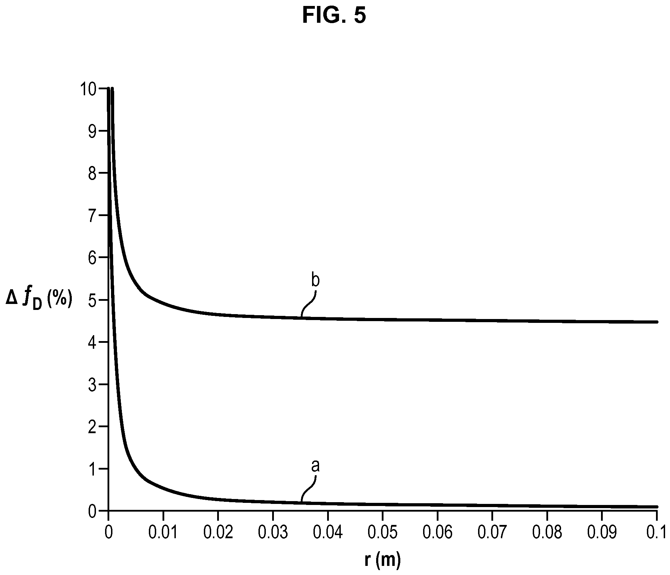

Selon un autre mode de réalisation, comme illustré sur les figures 2A et 5A, le volume de mesure est incliné d'un angle θ par rapport à la normale à la surface principale S de la plaquette 2.

Les franges sont orientées sensiblement radialement, de préférence de telle sorte que la distance interfranges varie entre une distance minimale dmin à l'extrémité du volume de mesure la plus éloignée de l'axe de rotation de la plaquette et une distance maximale dmax à l'extrémité du volume de mesure la plus proche de l'axe de rotation de la plaquette. L'amplitude de variation d'une extrémité à l'autre du volume de mesure peut être de l'ordre de ± 35% autour d'une valeur nominale, et peut aller par exemple jusqu'à ± 50% autour d'une valeur nominale.

Les figures 3A et 3B illustrent le volume de mesure par rapport à la surface S de la plaquette, respectivement en vue de côté et en vue de dessus. Les distances d1 et d2 correspondent aux distances interfranges aux intersections du volume de mesure avec la plaquette.

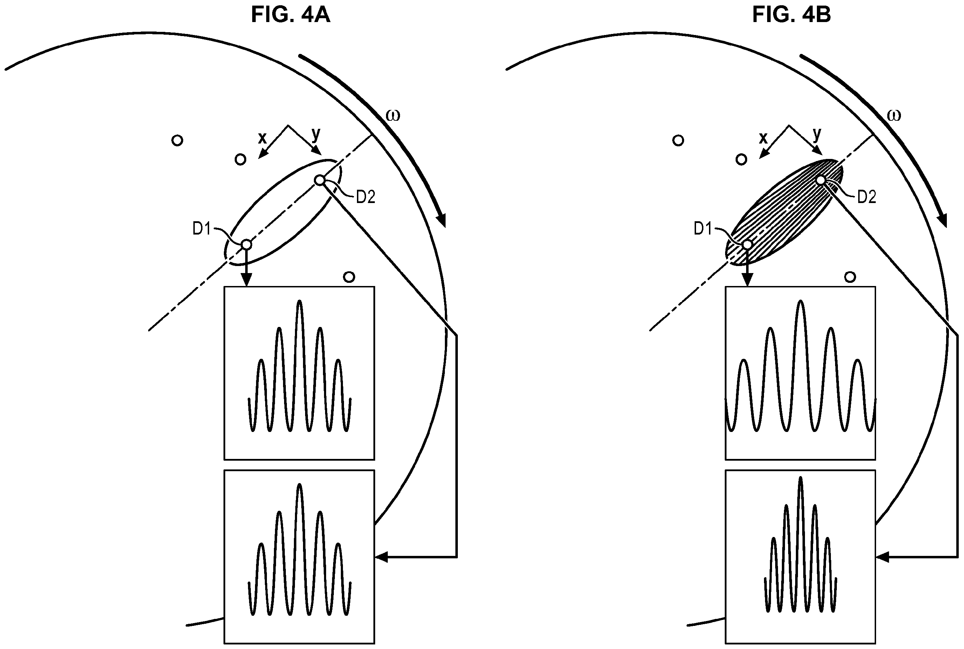

L'effet d'un tel volume de mesure sur la résolution de détection de la position radiale d'un défaut apparaît par comparaison des figures 4A et 4B.

La figure 4A correspond à un procédé d'inspection dans lequel la distance interfranges est constante dans le volume de mesure V, c'est-à-dire que les franges sont parallèles. Dans ce cas, deux défauts D1 et D2 passant dans ledit volume de mesure V génèrent des bouffées Doppler de même fréquence. Ces bouffées Doppler sont représentées dans les deux rectangles.

La figure 4B correspond à un procédé d'inspection selon une forme d'exécution de l'invention, dans laquelle la distance interfranges varie linéairement en croissant vers le centre de la plaquette. Dans ce cas, les défauts D1 et D2 qui passent dans le volume de mesure V traversent des franges présentant des interfranges différentes et génèrent chacun une bouffée Doppler de fréquence différente, puisque la fréquence de la bouffée Doppler dépend de la distance interfranges.

Ainsi, en connaissant la fréquence Doppler et la vitesse du défaut, on peut déterminer la position dudit défaut, avec une résolution plus grande.

A titre d'exemple, le volume de mesure peut présenter les dimensions suivantes : x * y * z = 220 * y * 80 μm (la dimension y n'ayant pas d'importance dans le cas d'espèce), et peut être incliné d'un angle θ = 30° par rapport à la normale à la surface S de la plaquette. D'une manière générale, on choisit dans ce mode de réalisation un angle compris entre 10 et 80° par rapport à la normale à la surface principale de la plaquette. La distance interfranges peut être choisie pour mesurer 1,4 μm ± 10% en variant linéairement dans la direction radiale x. Par conséquent, la distance interfranges minimale dmin est égale à 1,26 μm et la distance interfranges maximale dmax est égale à 1,54 μm. Dans cette configuration, la distance interfranges varie, dans la partie du volume de mesure à l'intersection avec la plaquette, entre une valeur d1 = 1,37 μm et une valeur d2 = 1,43 μm, soit une variation de 0,06 μm d'une extrémité à l'autre de cette partie du volume de mesure.

La figure 5 présente les courbes de variation de la fréquence Doppler (en %) en fonction de la distance r par rapport au centre de la plaquette, pour un volume de mesure dans lequel les franges d'interférences sont parallèles (courbe (a)) et pour un volume de mesure selon le premier mode de réalisation de l'invention (courbe (b)).

On observe que dans le cas d'une distance interfranges constante, la variation de fréquence Doppler est très faible à l'exception de la partie centrale de la plaquette.

En revanche, dans le cas d'une distance interfranges variant radialement, la variation de fréquence Doppler d'une extrémité à l'autre du volume de mesure est au minimum de 4,5 % et est donc mesurable en tout point de la surface de la plaquette. En supposant que l'on peut détecter des différences de fréquence de l'ordre du %, l'utilisation d'un volume de mesure présentant une distance interfranges variable permet d'augmenter presque d'un facteur 5 la résolution de la détermination de la position radiale des défauts.

Outre l'amélioration de la résolution de la détermination de la position radiale des défauts, la mise en oeuvre d'un volume de mesure présentant une distance interfranges variable présente l'avantage de simplifier notablement la conception du dispositif interférométrique. En effet, dans les systèmes d'inspection connus, on cherche à obtenir un parfait parallélisme des franges afin d'éviter des imprécisions de mesure. Cette exigence implique des contraintes sévères dans la conception et la fabrication du dispositif interférométrique. En allant à l'encontre de la pratique habituelle dans le domaine de l'inspection, l'invention permet également de s'affranchir des contraintes de conception et de fabrication et peut donc être mise en oeuvre beaucoup plus facilement que dans les systèmes d'inspection de plaquettes opaques connus.

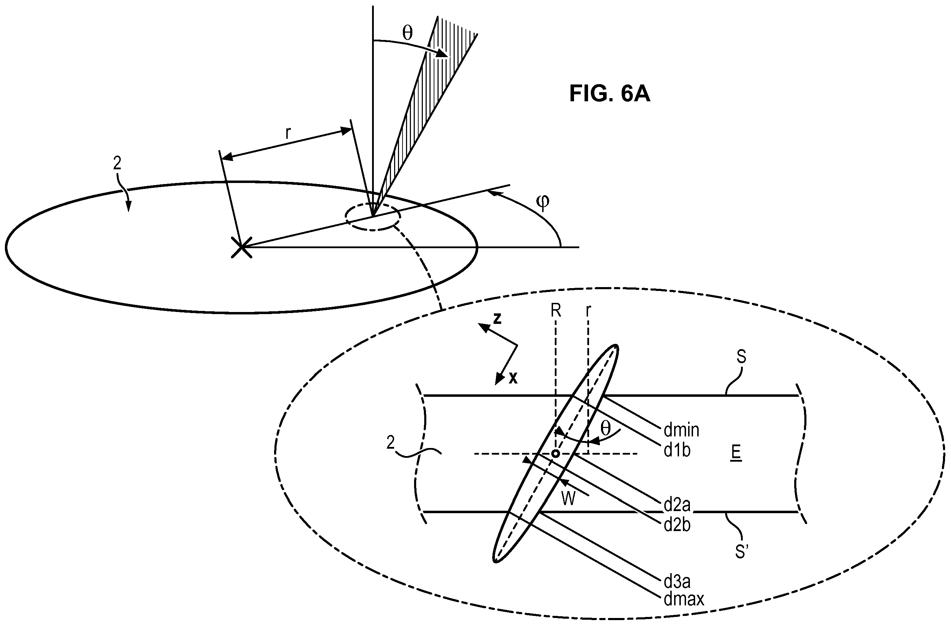

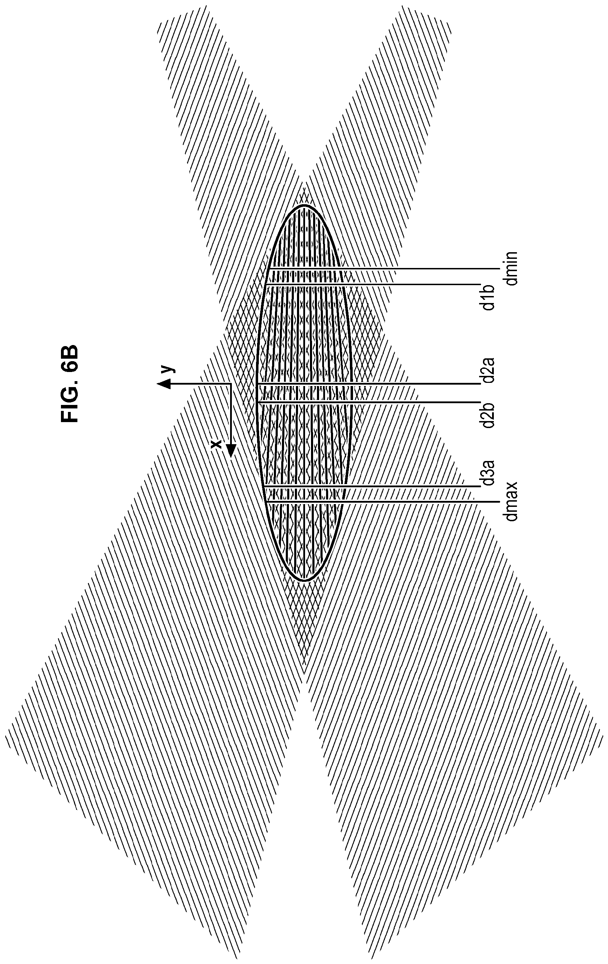

Les figures 6A et 6B illustrent un deuxième mode de réalisation de l'invention. Comme dans le premier, on forme un volume de mesure contenant des franges dont la distance interfranges est variable. Cependant, dans ce cas, on incline le volume de mesure dans une direction proche de la normale à la surface de la plaquette (angle θ de l'ordre de 0 à 30°).

La plaquette étant au moins partiellement transparente à la longueur d'onde du faisceau incident, le volume de mesure s'étend au travers de la plaquette 2. Par conséquent, quel que soit l'emplacement d'un défaut (sur la surface principale S située du côté du dispositif interférométrique, sur la surface principale opposée S' ou dans l'épaisseur E de la plaquette), ce défaut génère une bouffée Doppler et peut donc être détecté.

La variabilité de la distance interfranges permet de déterminer plus précisément la position du défaut dans le sens de l'épaisseur de la plaquette. En effet, comme on peut le voir sur la figure 6B, la distance interfranges varie linéairement dans le sens de l'épaisseur et dans la direction radiale, entre une distance minimale (dmin, d1b) et une distance maximale (d3a, dmax), en passant par une distance intermédiaire (d2a, d2b) au centre du volume de mesure. Ainsi, un défaut présent sur la surface S ne génère pas une bouffée Doppler de la même fréquence qu'un défaut présent dans l'épaisseur E ou qu'un défaut présent sur la surface S'.

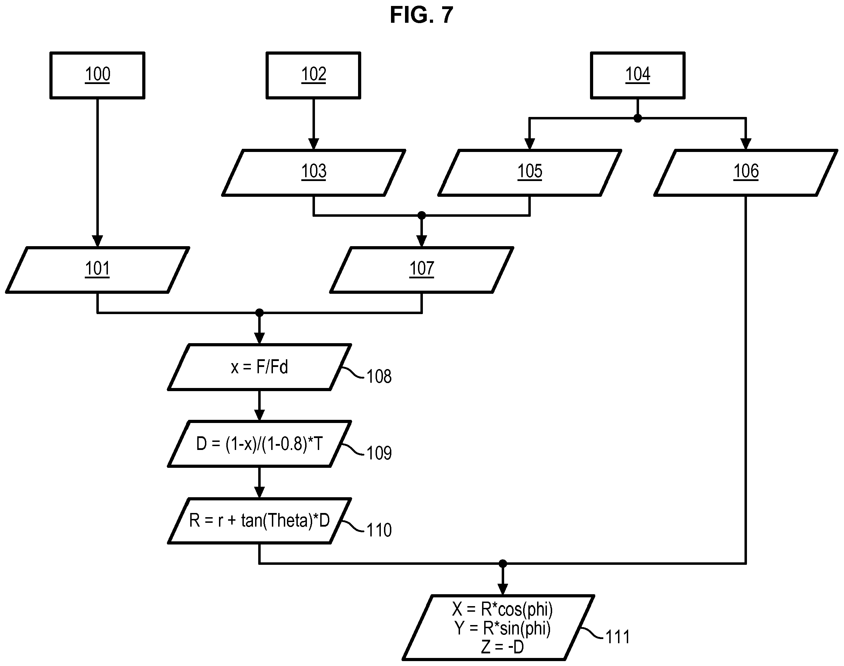

La figure 7 est un logigramme présentant les différentes étapes de la localisation d'un défaut dans le volume de la plaquette.

Les paramètres mentionnés dans cette figure sont définis ainsi :

r : position radiale du point de la surface balayé par le volume de mesure,

φ : position tangentielle du point de la surface balayé par le volume de mesure,

F : fréquence Doppler détectée (signature Doppler du défaut détecté),

Fd : fréquence Doppler théorique d'un défaut présent à la surface de la plaquette, à une distance radiale r,

x : ratio entre la fréquence Doppler mesurée et la fréquence Doppler théorique (x = F/Fd),

T : épaisseur de la plaquette,

D : profondeur déduite,

θ : angle entre le volume de mesure et la normale à la plaquette,

R : position radiale réelle du défaut détecté dans l'épaisseur de la plaquette.

Dans la mesure où la distance interfranges diminue linéairement le long de l'épaisseur de la plaquette, la profondeur du défaut est donnée par la formule suivante :

$$D = \frac{(1-x)}{(1-0,8)} * T$$

Par ailleurs, dans la mesure où les faisceaux incidents formant le volume de mesure sont inclinés d'un angle θ par rapport à la normale à la surface de la plaquette, un défaut détecté dans l'épaisseur de la plaquette n'aura pas pour position radiale r mais :

$$R = r + D* \tan(\theta)$$

Dans cette approche, on suppose que tous les points du volume de mesure ont la même vitesse linéaire, c'est-à-dire que l'on néglige la variation de vitesse tangentielle liée au fait que les défauts présents à différentes profondeurs dans la plaquette ont une position radiale différente. Cependant, comme expliqué pour le premier mode de réalisation, ce phénomène peut éventuellement être mis à profit dans le second mode de réalisation pour améliorer encore la résolution de détection.

Comme on peut le voir sur la figure 7, le procédé de détection d'un défaut comprend les étapes suivantes.

L'étape 100 comprend l'acquisition de la lumière rétro-diffusée et l'émission d'un signal électrique représentatif de l'intensité de la lumière diffusée en fonction du temps, traduisant la présence d'un défaut dans ou sur la plaquette.

L'étape 101 comprend la détermination de la fréquence Doppler correspondante, notée F).

L'étape 102 comprend l'obtention des données d'encodage de la position radiale du défaut détecté et l'étape 103 comprend la détermination, à partir de ces données, de la position radiale r dudit défaut détecté.

L'étape 104 comprend l'obtention des données d'encodage en rotation de la plaquette.

Elle permet de déterminer d'une part la vitesse de rotation de la plaquette (étape 105) et la position tangentielle du défaut détecté (angle φ) (étape 106).

A l'étape 107, la combinaison de la position radiale du défaut et de la vitesse de rotation de la plaquette permet de déterminer la fréquence Doppler théorique du défaut (notée Fd).

Les étapes 108, 109 et 110 sont des étapes de calcul, respectivement, du ratio x entre la fréquence Doppler détectée et la fréquence Doppler théorique du défaut, la profondeur D du défaut à partir de la formule exposée plus haut, puis la position radiale réelle R du défaut, selon la formule exposée plus haut.

Enfin, à l'étape 111, la combinaison des résultats de ces calculs et de l'angle φ permet de déterminer la position (X, Y, Z) du défaut dans les trois directions.

Le procédé de détection qui vient d'être décrit permet, grâce à un volume de mesure qui s'étend au travers de l'épaisseur de la plaquette, de détecter un défaut quel que soit son emplacement dans la direction de l'épaisseur de la plaquette.

Il peut cependant être intéressant, dans certaines situations, de chercher à limiter la dimension du volume de mesure dans la direction de l'épaisseur de la plaquette.

A cet effet, l'invention peut comprendre, dans un mode de réalisation particulier, l'utilisation d'un filtre passe-bande présentant une sélectivité élevée.

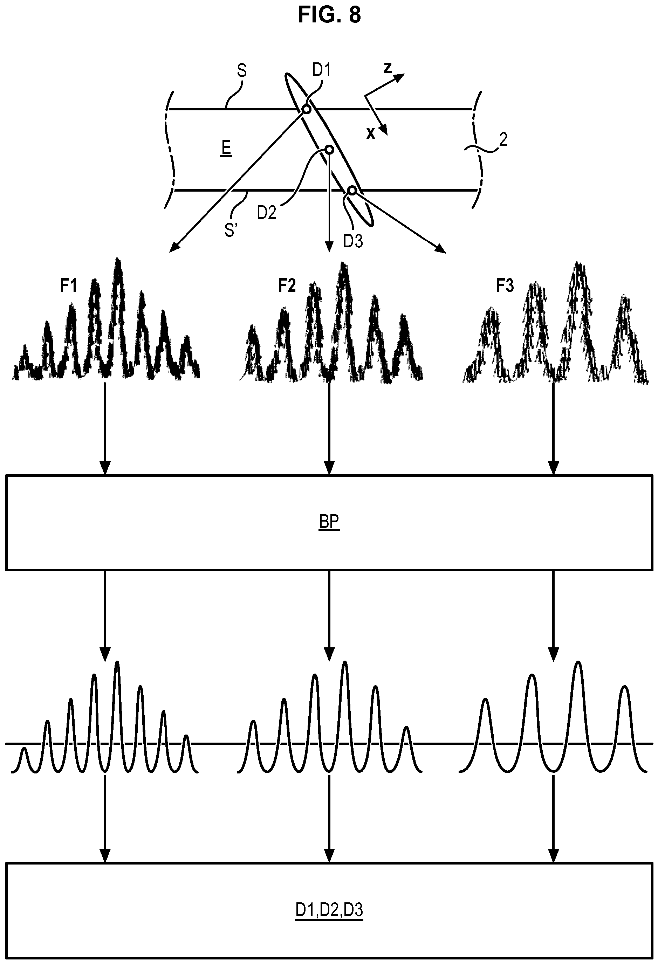

Comme illustré sur la figure 8, on utilise généralement un filtre passe-bande BP pour ne laisser passer, dans le signal électrique, que la fréquence Doppler associée au volume de mesure et une gamme étroite de fréquences autour de cette fréquence. Si l'on souhaite pouvoir détecter un défaut quel que soit son emplacement dans l'épaisseur de la plaquette, ce filtre présente une sélectivité modérée, pour tenir compte de la variation de fréquence Doppler due à la variation de la distance interfranges d'une face à l'autre de la plaquette. Un tel filtre fournit donc un signal filtré qui contient la signature Doppler F1, F2, F3 d'un défaut D1, D2, D3 respectif quel que soit son emplacement.

Pour ne détecter sélectivement que les défauts présents à une profondeur déterminée dans l'épaisseur de la plaquette, on met en oeuvre un filtre hautement sélectif, c'est-à-dire dont la bande passante correspond exactement à la fréquence Doppler associée à cette profondeur, et qui ne laisse passer aucune autre fréquence. Dans la mesure où la distance interfranges est variable dans la direction de l'épaisseur de la plaquette, chaque profondeur est en effet associée à une fréquence Doppler différente. Ainsi, dans l'exemple illustré, le filtre HS BP sélectionne la fréquence F1 qui est la fréquence Doppler associée à la surface principale S de la plaquette. Cela signifie que le signal en sortie du filtre ne contiendra que la fréquence Doppler du défaut D1 présent sur cette surface, mais pas celle du défaut D2 présent dans l'épaisseur E de la plaquette ni le défaut D3 présent sur la surface S' opposée.

Par le biais de ce filtrage, on réduit ainsi le volume de mesure dans la direction de l'épaisseur.

Par ailleurs, dans la mesure où le volume de mesure est incliné par rapport à la normale à la surface principale de la plaquette, ledit filtrage a aussi pour effet de réduire le volume de mesure dans la direction radiale. En effet, comme illustré sur la figure 6B qui a été décrite plus haut, la distance interfranges à la surface S de la plaquette varie entre une valeur d1a et une valeur d1b. En choisissant un filtre dont la bande passante [$d_{start}$ - $d_{end}$] est telle que d1a < $d_{start}$ < $d_{end}$ < d1b, on réduit le volume de mesure dans la direction radiale.

A titre d'exemple, les inventeurs ont fabriqué un système comprenant un dispositif optique intégré tel que décrit plus haut, permettant de former un volume de mesure de 300 $\mu$m de profondeur (dans la direction de l'épaisseur de la plaquette) et présentant une distance interfranges variant entre 0,8 et 1,2 $\mu$m. Dans le cas où un défaut traverse ce volume à une vitesse de 10 m/s, les fréquences Doppler associées sont comprises entre 12,5 MHz et 8,3 MHz.

Si l'on souhaite un volume de mesure centré sur une distance interfranges de 1 $\mu$m et présentant une profondeur de 50 $\mu$m (ce qui correspond à une variation de la distance interfranges entre 0,95 et 1,05 $\mu$m), il faut appliquer un filtre présentant une bande passante de 9,5 MHz à 10,5 MHz. Plus les pentes de ce filtre passe-bande sont grandes, plus grande est la sélectivité du filtre.

Si l'on souhaite un volume de mesure de 10 $\mu$m, la bande passante s'étend entre 9,9 MHz et 11 MHz.

Naturellement, les caractéristiques du filtre dépendent de la vitesse des défauts, mais l'homme du métier est en mesure de déterminer, en fonction de la vitesse de rotation de la plaquette, la bande passante du filtre adapté pour obtenir un volume de mesure déterminé.

## REFERENCES

WO 2009/112704

WO 02/39099

Integrated Laser Doppler Velocimeter for Fluid Velocity and Wall Friction Measurements, P. Lemaitre-Auger, A. Cartellier, P. Benech et Schanen Duport, Sensors, 2002, Proceedings of IEEE (Vol:1), pp. 78-82

## Revendications

1. Procédé d'inspection d'une plaquette (2) pour l'électronique, l'optique ou l'optoélectronique, comprenant :

   - la mise en rotation de la plaquette (2) autour d'un axe de symétrie (X) perpendiculaire à une surface principale (S) de ladite plaquette,
   - l'émission, à partir d'une source lumineuse (20) couplée à un dispositif interférométrique (30), de deux faisceaux lumineux incidents quasi-collimatés, de sorte à former, à l'intersection entre les deux faisceaux, un volume de mesure contenant des franges d'interférence s'étendant transversalement à la trajectoire de rotation de la plaquette et présentant une distance interfranges variable dans le volume de mesure, ladite plaquette étant au moins partiellement transparente à la longueur d'onde de la source lumineuse,

   le dispositif interférométrique (30) et la plaquette (2) étant agencés l'un par rapport à l'autre de sorte que le volume de mesure s'étende dans une région de la plaquette, l'épaisseur de ladite région étant inférieure à l'épaisseur de la plaquette,

   - la collecte d'au moins une partie de la lumière diffusée par ladite région de la plaquette,
   - l'acquisition de la lumière collectée et l'émission d'un signal électrique représentant la variation de l'intensité lumineuse de la lumière collectée en fonction du temps,
   - la détection, dans ledit signal, d'une composante fréquentielle dans la variation de l'intensité de ladite lumière collectée, ladite composante fréquentielle étant la signature temporelle du passage d'un défaut dans le volume de mesure, la dite signature temporelle du passage d'un défaut dans le volume de mesure étant dépendante de la valeur de la distance interfrange à l'endroit de passage du défaut dans le volume de mesure, - la détermination, à partir de ladite composante fréquentielle de la valeur de la distance interfranges à l'endroit de passage du défaut et de la position dudit défaut dans la direction radiale et/ou dans l'épaisseur de la plaquette.

**2.** Procédé selon la revendication 1, dans lequel ledit dispositif interférométrique (30) est un dispositif optique intégré comprenant un guide de lumière dont l'entrée est couplée à la source lumineuse et qui se divise en deux branches dont la sortie est orientée pour former ledit volume de mesure à l'intersection des deux faisceaux,

**3.** Procédé selon l'une des revendications 1 ou 2, dans lequel la distance interfranges varie dans la direction radiale de la plaquette.

**4.** Procédé selon l'une des revendications 1 à 3, dans lequel la distance interfranges varie entre une distance minimale à l'extrémité du volume de mesure la plus éloignée de l'axe de rotation de la plaquette et une distance maximale à l'extrémité du volume de mesure la plus proche de l'axe de rotation de la plaquette.

**5.** Procédé selon l'une des revendications 1 à 4, dans lequel, dans le volume de mesure, la distance interfranges varie dans un intervalle de ± 50% autour d'une valeur nominale.

**6.** Procédé selon l'une des revendications 1 à 5, dans lequel le volume de mesure est incliné d'un angle compris entre 10 et 80° par rapport à la normale à la surface principale (S) de la plaquette.

**7.** Procédé selon l'une des revendications 1 à 5, dans lequel le volume de mesure est incliné d'un angle compris entre 0 et 40° par rapport à la normale à la surface principale (S) de la plaquette.

**8.** Procédé selon la revendication 7, comprenant en outre la mise en oeuvre d'un filtrage passe-bande du signal, la bande passante dudit filtre étant sélectionnée pour ne transmettre que la partie du signal présentant la fréquence Doppler associée à une position déterminée dans l'épaisseur de la plaquette.

**9.** Système (1) d'inspection de plaquettes (2) pour l'électronique, l'optique ou l'optoélectronique, comprenant :

    - un dispositif (10) d'entraînement d'une plaquette en rotation autour d'un axe (X) de symétrie perpendiculaire à une surface principale (S) de ladite plaquette,
    - une source lumineuse (20) adaptée pour émettre un faisceau lumineux quasi-collimaté dont la longueur d'onde est choisie pour qu'au moins une partie dudit faisceau soit transmise au travers de la plaquette (2),

    - un dispositif interférométrique (30) couplé à la source lumineuse pour diviser le faisceau émis par ladite source (20) en deux faisceaux et pour former, à l'intersection entre les deux faisceaux, un volume de mesure respectif contenant des franges d'interférence s'étendant transversalement à la trajectoire de rotation de la plaquette, la distance interfranges étant variable dans ledit volume de mesure, ledit volume de mesure s'étendant dans une région de la plaquette, l'épaisseur de ladite région étant inférieure à l'épaisseur de la plaquette,
    - un dispositif (40) de collecte de la lumière diffusée par la plaquette,
    - un dispositif (50) d'acquisition de la lumière collectée configuré pour émettre un signal électrique représentant la variation de l'intensité lumineuse de la lumière collectée en fonction du temps,
    - un dispositif (60) de traitement configuré pour détecter, dans ledit signal, une composante fréquentielle dans la variation de l'intensité de ladite lumière collectée, ladite composante fréquentielle étant la signature temporelle du passage d'un défaut dans le volume de mesure respectif et dépendant de la valeur de la distance interfranges à l'endroit de passage du défaut dans le volume de mesure et pour déterminer, à partir de ladite composante fréquentielle, ladite valeur de la distance interfranges et la position du défaut dans la direction radiale et/ou dans l'épaisseur de la plaquette.

**10.** Système selon la revendication 9 dans lequel le dispositif interférométrique est un dispositif optique intégré.

**11.** Système selon l'une des revendications 9 ou 10, comprenant en outre un bras pour déplacer le dispositif interférométrique (30) et le dispositif (40) de collecte de la lumière diffusée en translation dans une direction radiale.

**Patentansprüche**

**1.** Verfahren zum Prüfen eines Wafers (2) für die Elektronik, die Optik oder die Optoelektronik, umfassend:

    - das Indrehungversetzen des Wafers (2) um eine zu einer Hauptfläche (S) des Wafers senkrechte Symmetrieachse (X),
    - das Aussenden von zwei quasi-kollimierten einfallenden Lichtstrahlen aus einer mit einer interferometrischen Vorrichtung (30) gekoppelten Lichtquelle (20), um an der Kreuzung zwischen den beiden Strahlen ein Messvolumen zu bilden, das Interferenzstreifen enthält, die sich quer zur Rotationsbahn des Wafers erstrecken und einen im Messvolumen variablen Zwischenstreifenabstand aufweisen, wobei der Wafer bei der Wellenlänge der Lichtquelle wenigstens teilweise transparent ist,

wobei die interferometrische Vorrichtung (30) und der Wafer (2) so zueinander angeordnet sind, dass sich das Messvolumen in einem Bereich des Wafers erstreckt, wobei die Dicke des Bereichs kleiner als die Dicke des Wafers ist,

- das Sammeln von wenigstens einem Teil des durch den Bereich des Wafers gestreuten Lichts,

- das Erfassen des gesammelten Lichts und das Senden eines elektrischen Signals, das die Änderung der Lichtintensität des gesammelten Lichts in Abhängigkeit von der Zeit darstellt,

- das Erfassen, in dem Signal, einer Frequenzkomponente in der Änderung der Intensität des gesammelten Lichts, wobei die Frequenzkomponente die Zeitsignatur des Durchgangs eines Fehlers in dem Messvolumen ist, wobei die Zeitsignatur des Durchgangs eines Fehlers in dem Messvolumen von dem Wert des Zwischenstreifenabstands an der Durchgangsstelle des Fehlers in dem Messvolumen abhängig ist,

- das Bestimmen des Wertes des Zwischenstreifenabstands an der Durchgangsstelle des Fehlers und der Position des Fehlers in der radialen Richtung und/oder in der Dicke des Wafers anhand der Frequenzkomponente.

**2.** Verfahren nach Anspruch 1, bei dem die interferometrische Vorrichtung (30) eine integrierte optische Vorrichtung ist, die einen Lichtleiter aufweist, dessen Eingang mit der Lichtquelle gekoppelt ist und der sich in zwei Zweige aufteilt, deren Ausgang ausgerichtet ist, um das Messvolumen an der Kreuzung der beiden Strahlen zu bilden.

**3.** Verfahren nach einem der Ansprüche 1 oder 2, bei dem der Zwischenstreifenabstand in der radialen Richtung des Wafers variiert.

**4.** Verfahren nach einem der Ansprüche 1 bis 3, bei dem der Zwischenstreifenabstand zwischen einem minimalen Abstand an dem Ende des Messvolumens, das von der Rotationsachse des Wafers am weitesten entfernt ist, und einem maximalen Abstand an dem Ende des Messvolumens, das der Rotationsachse des Wafers am nächsten ist, variiert.

**5.** Verfahren nach einem der Ansprüche 1 bis 4, bei dem der Zwischenstreifenabstand in dem Messvolumen in einem Bereich von $\pm$ 50 % um einen Nennwert herum variiert.

**6.** Verfahren nach einem der Ansprüche 1 bis 5, bei dem das Messvolumen um einen Winkel zwischen 10 und 80° in Bezug auf die Normale zur Hauptfläche (S) des Wafers geneigt ist.

**7.** Verfahren nach einem der Ansprüche 1 bis 5, bei dem das Messvolumen um einen Winkel zwischen 0 und 40° in Bezug auf die Normale zur Hauptfläche (S) des Wafers geneigt ist.

**8.** Verfahren nach Anspruch 7, ferner umfassend das Durchführen einer Bandpassfilterung des Signals, wobei die Bandbreite des Filters ausgewählt ist, um nur den Teil des Signals zu übertragen, der die einer bestimmten Position in der Dicke des Wafers zugeordnete Dopplerfrequenz aufweist.

**9.** System (1) zum Prüfen von Wafern (2) für die Elektronik, die Optik oder die Optoelektronik, umfassend:

- eine Vorrichtung (10) zum Drehantreiben eines Wafers um eine zu einer Hauptfläche (S) des Wafers senkrechte Symmetrieachse (X),

- eine Lichtquelle (20), die dazu ausgelegt ist, einen quasi-kollimierten Lichtstrahl auszusenden, dessen Wellenlänge so gewählt ist, dass wenigstens ein Teil des Strahls durch den Wafer (2) übertragen wird,

- eine interferometrische Vorrichtung (30), die mit der Lichtquelle (20) gekoppelt ist, um den durch die Quelle (20) ausgesandten Strahl in zwei Strahlen zu teilen und um an der Kreuzung zwischen den beiden Strahlen ein jeweiliges Messvolumen zu bilden, das Interferenzstreifen enthält, die sich quer zur Rotationsbahn des Wafers erstrecken, wobei der Zwischenstreifenabstand in dem Messvolumen variabel ist, wobei das Messvolumen sich in einem Bereich des Wafers erstreckt, wobei die Dicke des Bereichs kleiner als die Dicke des Wafers ist,

- eine Vorrichtung (40) zum Sammeln des durch den Wafer gestreuten Lichts,

- eine Vorrichtung (50) zum Erfassen des gesammelten Lichts, die dazu ausgebildet ist, ein elektrisches Signals zu senden, das die Änderung der Lichtintensität des gesammelten Lichts in Abhängigkeit von der Zeit darstellt,

- eine Verarbeitungsvorrichtung (60), die dazu ausgebildet ist, in dem Signal eine Frequenzkomponente in der Änderung der Intensität des gesammelten Lichts zu erfassen, wobei die Frequenzkomponente die Zeitsignatur des Durchgangs eines Fehlers in dem jeweiligen Messvolumen ist und von dem Wert des Zwischenstreifenabstands an der Durchgangsstelle des Fehlers in dem Messvolumen abhängig ist, und anhand der Frequenzkomponente den Wert des Zwischenstreifenabstands und die Position des Fehlers in der radialen Richtung und/oder in der Dicke des Wafers zu bestimmen.

10. System nach Anspruch 9, bei dem die interferometrische Vorrichtung eine integrierte optische Vorrichtung ist.

11. System nach einem der Ansprüche 9 oder 10, ferner umfassend einen Arm, um die interferometrische Vorrichtung (30) und die Vorrichtung (40) zum Sammeln des Streulichts in einer radialen Richtung verschiebend zu bewegen.


**Claims**

1. Method for inspecting a wafer (2) for electronics, optics or optoelectronics, comprising:

   - rotating the wafer (2) about an axis of symmetry (X) perpendicular to a main surface (S) of said wafer,
   - emitting, from a light source (20) coupled with an interferometric device (30), two quasi-collimated incident light beams, so as to form, at the intersection between the two beams, a measurement volume containing interference fringes extending transversally to the path of rotation of the wafer and having a variable inter-fringe distance within the measurement volume, said wafer being at least partially transparent at the wavelength of the light source,
   the interferometric device (30) and the wafer (2) being arranged in relation to one another so that the measurement volume extends into a region of the wafer, the thickness of said region being less than the thickness of the wafer,
   - collecting at least a portion of the light scattered by said region of the wafer,
   - capturing the collected light and emitting an electrical signal representing the variation in the light intensity of the collected light as a function of time,
   - detecting, in said signal, a frequency component in the variation of the intensity of said collected light, said frequency component being the time signature of the passage of a defect through the measurement volume,
   the time signature of the passage of a defect through the measurement volume depending on the value of the inter-fringe distance at the location where the defect passes through the measurement volume,
   - determining, based on said frequency component, the value of the inter-fringe distance at the location where the defect passes and the position of said defect in the radial direction and/or in the thickness of the wafer.

2. Method according to claim 1, in which said interferometric device (30) is an integrated optical device comprising a light guide the input of which is coupled with the light source and which is divided into two branches, the output of which is oriented in order to form said measurement volume at the intersection of the two beams.

3. Method according to either one of claims 1 or 2, in which the inter-fringe distance varies in the radial direction of the wafer.

4. Method according to one of claims 1 to 3, in which the inter-fringe distance varies between a minimum distance at the furthest end of the measurement volume from the axis of rotation of the wafer and a maximum distance at the closest end of the measurement volume to the axis of rotation of the wafer.

5. Method according to one of claims 1 to 4, in which in the measurement volume, the inter-fringe distance varies within an interval of $\pm$ 50% around a nominal value.

6. Method according to one of claims 1 to 5, in which the measurement volume is inclined by an angle comprised between 10 and 80° with respect to the normal to the main surface (S) of the wafer.

7. Method according to one of claims 1 to 5, in which the measurement volume is inclined by an angle comprised between 0 and 40° with respect to the normal to the main surface (S) of the wafer.

8. Method according to claim 7, also comprising the utilization of a band-pass filtering of the signal, the pass-band of said filter being selected so as to transmit only the portion of the signal having the Doppler frequency associated with a determined position in the thickness of the wafer.

9. System (1) for inspecting wafers (2) for electronics, optics or optoelectronics, comprising:

   - a device (10) for driving a wafer in rotation about an axis (X) of symmetry perpendicular to a main surface (S) of said wafer,
   - a light source (20) suitable for emitting a quasi-collimated light beam the wavelength of which is chosen so that at least a portion of said beam is transmitted through the wafer (2),
   - an interferometric device (30) coupled with the light source in order to divide the beam emitted by said source (20) into two beams and in order to form, at the intersection between the two beams, a respective measurement volume containing interference fringes extending transversally to the path of rotation of the wafer, the inter-fringe distance being variable within said measurement volume, the measurement volume extending into a region of the wafer, the thickness of said region being less than the thickness of the wafer,

- a device (40) for collecting light scattered by the wafer,

- a device (50) for capturing collected light configured in order to emit an electrical signal representing the variation in the light intensity of the collected light as a function of time,

- a processing device (60) configured in order to detect, in said signal, a frequency component in the variation of the intensity of said collected light, said frequency component being the time signature of the passage of a defect through the respective measurement volume and dependent on the value of the inter-fringe distance at the location where the defect passes through the measurement volume and in order to determine, based on said frequency component, said value for the inter-fringe distance and the position of the defect in the radial direction and/or in the thickness of the wafer.

10. System according to claim 9, in which the interferometric device is an integrated optical device.

11. System according to one of claims 9 or 10, also comprising an arm for moving the interferometric device (30) and the device for the collection of scattered light (40) in translational motion in a radial direction.

# FIG. 1

# FIG. 2

FIG. 3A                    FIG. 3B

EP 3 201 610 B1

FIG. 4A

FIG. 4B

EP 3 201 610 B1

**FIG. 5**

FIG. 6A

θ

r

2

φ

z

x

R

r

θ

dmin

d1b

2

E

W

d2a

d2b

d3a

dmax

S

S'

EP 3 201 610 B1

FIG. 6B

d3a  d2b  d2a  d1b
dmax          dmin

**FIG. 7**

EP 3 201 610 B1

Flowchart:

Box 100 → 101

Box 102 → 103

Box 104 → 105 and 106

103 and 105 → 107

101 and 107 →

108: x = F/Fd

109: D = (1-x)/(1-0.8)*T

110: R = r + tan(Theta)*D

111:
X = R*cos(phi)
Y = R*sin(phi)
Z = -D

# FIG. 8

# FIG. 9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2009112704 A

- WO 0239099 A

**Littérature non-brevet citée dans la description**

- **P. LEMAITRE-AUGER.** *Integrated Laser Doppler Velocimeter for Fluid Velocity and Wall Friction Measurements*

- **P. LEMAITRE-AUGER ; A. CARTELLIER ; P. BENECH ; SCHANEN DUPORT.** Integrated Laser Doppler Velocimeter for Fluid Velocity and Wall Friction Measurements. *Proceedings of IEEE,* 2002, (1), 78-82